**Europäisches Patentamt**

**European Patent Office**

**Office européen des brevets**

(19)

(11) Veröffentlichungsnummer: **0 227 857**
**B1**

(12)

# EUROPÄISCHE PATENTSCHRIFT

(45) Veröffentlichungstag der Patentschrift:
28.03.90

(21) Anmeldenummer: 85116653.8

(22) Anmeldetag: 30.12.85

(51) Int. Cl.⁴: **H05K 3/38,** H05K 3/10,
H05K 3/42

(54) Verfahren zum Herstellen von gedruckten Schaltungen.

(43) Veröffentlichungstag der Anmeldung:
08.07.87 Patentblatt 87/28

(45) Bekanntmachung des Hinweises auf die Patenterteilung:
28.03.90 Patentblatt 90/13

(84) Benannte Vertragsstaaten:
DE FR GB

(56) Entgegenhaltungen:
EP-A- 0 127 691
DE-A- 2 135 384
DE-A- 2 634 560
DE-A- 3 304 004
US-A- 2 982 625

IBM TECHNICAL DISCLOSURE BULLETIN, Band 27,
Nr. 6, November 1984, Seiten 3208-3209, New York, US;
C. CZEPLUCH et al.: "Method of improving the
adhesion of metallic layers on curable plastics"

(73) Patentinhaber: **IBM DEUTSCHLAND GMBH,
Pascalstrasse 100, D-7000 Stuttgart 80(DE)**

(84) Benannte Vertragsstaaten: **DE**

(73) Patentinhaber: **International Business Machines
Corporation, Old Orchard Road, Armonk, N.Y. 10504(US)**

(84) Benannte Vertragsstaaten: **FR GB**

(72) Erfinder: **Baehrle, Dieter, Cheruskerstrasse 67,
D-7036 Schönaich(DE)**
Erfinder: **Schwerdt, Friedrich, Nelkenstrasse 23,
D-7033 Herrenberg(DE)**
Erfinder: **Stehling, Jürgen H., Geranienstrasse 43,
D-7033 Herrenberg(DE)**

(74) Vertreter: **Kreidler, Eva-Maria, Dr. rer. nat., Schönaicher
Strasse 220, D-7030 Böblingen(DE)**

## Beschreibung

Die Erfindung betrifft ein Verfahren nach dem Oberbegriff des Patentanspruchs 1.

Bei der Herstellung von Leiterplatten nach dem heutigen Stand der Technik werden Leiterbahnen auf mehreren, sogenannten Signalebenen verteilt, welche mit dazwischenliegenden Prepregs und der erforderlichen Anzahl von Spannungsebenen eine Mehrlagenschaltung bilden. Die Mehrlagenschaltung wird anschließend an den gewünschten Stellen gebohrt, und durch die Verkupferung der Bohrlöcher wird ein Anschluß an die interne Verdrahtung hergestellt. An die Fertigung von Mehrlagenschaltungen werden heute wegen der hohen Dichte der Verdrahtung bezüglich der angewendeten Materialien und Verfahren besonders hohe Anforderungen gestellt.

Zur Herstellung von Leiterplatten werden zwei Verfahren, das subtraktive oder ein additives Verfahren, angewendet. In der Regel wurden bisher die Spannungsebenen nach dem subtraktiven Verfahren hergestellt. Bei diesem Verfahren ist das Ausgangsmaterial ein kupferkaschiertes Trägermaterial, z. B. eine glasfaserverstärkte Epoxidharzfolie, auf die ein- oder beidseitig eine z. B. 35 µm dicke Kupferfolie auflaminiert wird. Im Zuge der Weiterverarbeitung werden mehrere dieser Trägerplatten zu einem Paket zusammengepreßt und Löcher für Durchkontaktierungen mit numerisch gesteuerten Automaten gebohrt. Die Bohrungen werden durchkontaktiert, indem rein chemisch eine Basisschicht aus Kupfer an den Bohrungswandungen niedergeschlagen wird, die galvanisch verstärkt wird. Auf der Oberfläche der kupferkaschierten Trägerplatten wird dann in einem photolithographischen Verfahren ein Photoresistmuster erzeugt, das die gewünschten Leiterbahnen ausspart. Die Leiterplatte durchläuft dann eine Ätzanlage, die die Kupferschicht abätzt, wo sie nicht mehr durch den Photoresist geschützt ist. Nach der Entfernung des restlichen Resists befindet sind auf der Epoxidharz-Isolierschicht nur noch die gedruckte Schaltung.

Nachteilig an dem subtraktiven Verfahren ist, daß eine relativ dicke Kupferkaschierung aufgebracht werden muß, die dann durch Ätzen zum größten Teil wieder abgetragen werden muß. Die bei dem subtraktiven Verfahren auftretenden starken Unterätzungen führen außerdem zu einer Limitierung der Leiterzugbreite, so daß sich Leiterzugbreiten kleiner 100 µm nach diesem Verfahren nicht mehr herstellen lassen.

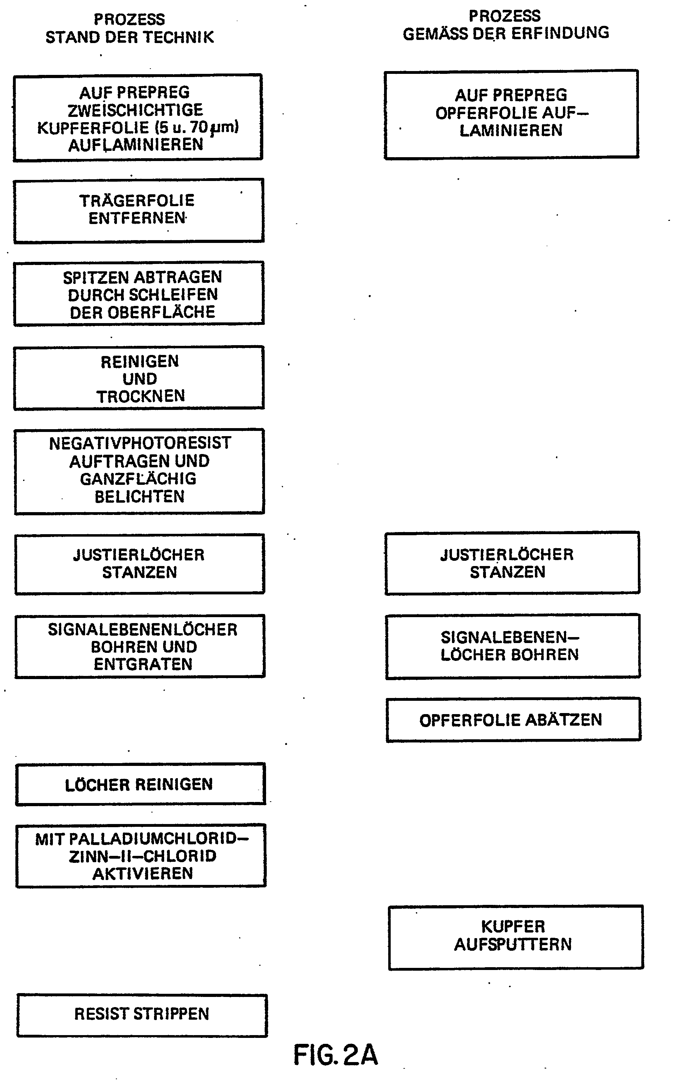

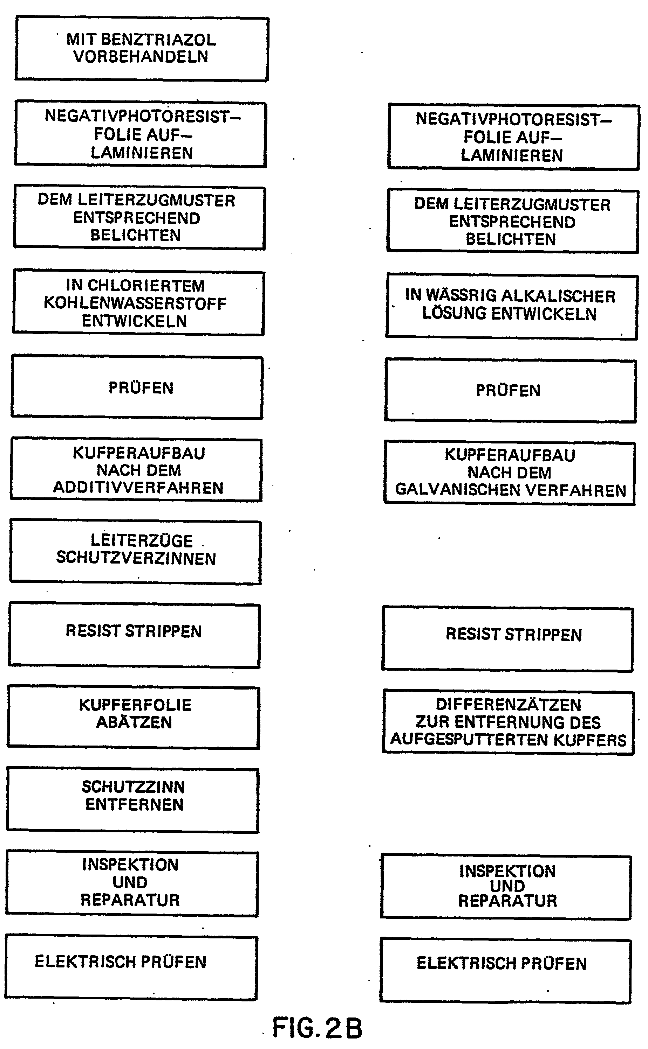

Aus diesen Gründen werden heute die Signalebenen in Mehrlagenschaltungen nach einem anderen Verfahren, dem Additivverfahren, hergestellt. Das zeitaufwendige und äußerst komplizierte Additivverfahren, welches beispielsweise bis zu acht Naßbäder und sechzehn dazwischengeschaltete Bäder umfaßt und anhand des Flußdiagramms in den Figuren 2A und 2B, linke Seite, näher erläutert wird, läuft so ab, daß auf ein aus vier Prepreglagen hergestelltes Trägermaterial beidseitig eine zweischichtige Kupferfolie (75 µm stark) auflaminiert wird. Die etwa 70 µm starke Trägerfolie wird anschließend entfernt. Die Oberflächen der so laminierten Teile werden anschließend geschliffen, gereinigt und getrocknet. Zur Erhöhung der Steifigkeit wird ein Negativphotoresist aufgetragen und ganzflächig belichtet. Nach dem Einstanzen von Justierlöchern werden die Signalebenenlöcher gebohrt und gereinigt. Anschließend werden die Bohrlochwandungen mit Palladiumchlorid-Zinn-(II)-chlorid aktiviert, und der zuvor aufgetragene Negativphotoresist wird gestrippt. Die Oberflächen der Teile werden mit Benztriazolhaftvermittler behandelt und mit einer Negativphotoresistfolie beschichtet, welche dem gewünschten Leiterzugmuster entsprechend belichtet und dann entwickelt wird. In diesem Zustand werden die Teile für ca. 20 Stunden in ein Kupferlangzeitbad getaucht. Während dieser Zeit scheidet sich Kupfer in den herausentwickelten Leiterzugkanälen auf der etwa 5 µm starken Kupferfolie und auf den Bohrlochwandungen bis zur gewünschten Dicke von etwa 40 µm ab. Im Anschluß an den Kupferaufbau bringt man auf die Kupferleitungen eine Zinnschicht auf. Nach dem Strippen des Photoresists wird in einem Ätzprozeß die dünne Kupferfolie, in den Bereichen, in denen sich keine mit Zinn geschützten Leiterzüge befinden, abgeätzt. Anschließend wird die Schutzverzinnung wieder entfernt. Das Herstellungsverfahren endet mit einer Inspektion und einer elektrischen Prüfung der Teile.

Nachteilig ist, daß bei dem zuvor beschriebenen Additivverfahren die zu verkupfernden Bohrlochwandungen mit Palladium aktiviert werden müssen, weil sich sonst kein Kupfer auf dem Epoxidharz abscheidet und weil das zur Aktivierung verwendete Palladium an allen ursprünglich aktivierten Stellen zurückbleibt und später zu Fehlstellen in der integrierten Schaltung führen kann. Die Photoresistmaterialien müssen gegen die beim Additivverfahren zur Anwendung kommenden stark alkalischen Verkupferungsbäder resistent sein. Diese Bedingungen werden im allgemeinen nur von Photoresistmaterialien erfüllt, welche in organischen Lösungsmitteln, wie chlorierten Kohlenwasserstoffen, löslich sind, und mit diesen entwickelt und gestrippt werden. Eine Schutzverzinnung der nach dem Additivverfahren hergestellten Leiterzüge ist erforderlich, weil eine Entfernung der Kupferfolie wegen ihrer Schichtdicke von 5 µm durch Differenzätzen in den Bereichen, in denen keine Leiterzüge sind, nicht durchführbar ist.

Aufgabe der Erfindung ist, ein Verfahren zur Herstellung einer gedruckten Schaltung anzugeben, das, verglichen mit den Verfahren gemäß dem Stand der Technik, einfacher durchführbar ist und das die zuvor geschilderten Nachteile vermeidet.

Die Aufgabe der Erfindung wird gelöst durch ein Verfahren mit den Merkmalen des Patentanspruchs 1.

Weitere Ausgestaltungen der Erfindung sind in den Unteransprüchen angegeben.

Das Verfahren der vorliegenden Erfindung benötigt eine Kupferfolie, durch die die Epoxidharzoberfläche aufgerauht wird und die gleichzeitig bei der Laminatherstellung als Trennfolie dienen kann. Diese Folie wird nach dem Bohren der Löcher mit herkömmlichen Ätzmedien abgeätzt. Die Aktivierung der so vorbereiteten Epoxidharzoberflächen wird durch einen Trockenprozeß, d. h. durch Aufsputtern einer dünnen Schicht Kupfer vorgenommen, daher können sämtliche Naßprozesse zur Aktivierung der Epoxidharzoberflächen und der Bohrlochwandungen entfallen. Der Aufbau der Leiterzüge erfolgt in einem galvanischen Prozeß, bei dem saure Bäder eingesetzt werden, so daß in wässrig alkalischen Medien lösliche und entwickelbare Photoresistmaterialien, welche gegen die sauren Bäder resistent sind, verwendet werden können. Es entfällt also auch die Verwendung chlorierter Kohlenwasserstoffe, welche eine erhebliche Belastung der Umwelt darstellen. Das galvanische Verkupfern findet auch, im Gegensatz zu dem stromlosen Verkupfern, um einen Faktor von etwa 10 bis 20 × schneller statt. Da das galvanische Bad praktisch frei von Komplexbildnern ist, ist es einfacher zu führen. Nach dem Strippen des Photoresists kann die sehr dünne aufgesputterte Kupferschicht durch Differenzätzen entfernt werden, so daß eine Schutzverzinnung der Leiterzüge nicht unbedingt erforderlich ist.

Gemäß der vorliegenden Erfindung wird eine Photoresistfolie, die in dem bisherigen Additivverfahren auf eine entsprechend vorbereitete Oberfläche einer auflaminierten Kupferfolie auflaminiert wurde, auf die Oberfläche eines Epoxidharzlaminates, von dem vorher eine Opferfolie aus Kupfer abgeätzt und das mit Kupfer besputtert wurde, auflaminiert. Durch dieses Vorgehen wird eine ausgezeichnete Haftung zwischen Photoresistfolie und der mit Kupfer besputterten Epoxidharzoberfläche erreicht, weil die Photoresistfolie beim Laminiervorgang in die Poren der aufgerauhten Oberfläche des Substrats hineingedrückt wird und sich dadurch nahtlos mit dem mit Kupfer besputterten Epoxidharzsubstrat verzahnt. Als Photoresist kann eine Negativphotoresistfolie verwendet werden, welche in wässrig-alkalischer Lösung entwickelbar ist. Nach dem Belichten und Entwickeln findet in den Photoresistkanälen, d. h. an den Stellen späterer Leiterzüge und an den Bohrlochwandungen auf dem aufgesputterten Kupfer ein Kupferaufbau nach dem galvanischen Verfahren statt. Dabei wächst Kupfer nach dem Einbringen in ein Elektrolysebad bis zur gewünschten Schichtdicke auf. Zur Fertigstellung der Signalebene wird der Photoresist gestrippt und das aufgesputterte Kupfer in den freigelegten Bereichen durch Differenzätzen entfernt. Weitere Folgeprozesse entfallen.

Aus der europäischen Patentanmeldung 0 127 691 ist zwar ein Verfahren zur Herstellung von gedruckten Schaltungen bekannt, bei dem beidseitig Opferfolien aus Kupfer auf ein Kunstharzprepreg auflaminiert werden, Verbindungslöcher gebohrt und anschließend die Opferfolie abgeätzt wird und dann direkt auf die durch das Abätzen aufgerauhte Oberfläche des Prepregs beidseitig eine Negativphotoresistfolie auflaminiert wird. Nach dem Erzeugen eines Leiterzugsmusters in dieser Negativphotoresistfolie wird Kupfer auf die Photoresistoberfläche und auf die Oberflächen der die Leiterzüge definierenden Photoresistkanäle und der Bohrlöcher durch Kathodenzerstäubung aufgesputtert. Das auf die Oberfläche des Photoresists aufgesputterte Kupfer wird mittels einer Schleifwalze wieder abgehoben. Auf dem in den Photoresistkanälen und den Bohrlöchern aufgesputterten Kupfer wächst anschließend nach dem Additivverfahren in einem stromlosen Bad Kupfer auf. Ein galvanisches Verkupfern ist in diesem Falle nicht möglich, da die durchgehende leitende Verbindung entfernt wurde. Das erfindungsgemäße Verfahren unterscheidet sich von diesem Verfahren dadurch, daß nach dem Abätzen der Opferfolien zunächst Kupfer ganzflächig auf die Oberflächen der Prepregs und der Signalebenenlöcher aufgesputtert wird. Danach wird eine Photoresistmaske auf der Prepregoberfläche erzeugt, und nach dem Kupferaufbau nach den galvanischen Verfahren wird der Resist gestrippt und das gesputterte Kupfer in den nunmehr freiliegenden Bereichen durch Differenzätzen entfernt.

Es sind auch zahlreiche Verfahren zum galvanischen Aufbau von Kupfer bekannt. So ist beispielsweise aus der deutschen Auslegeschrift 1 496 984 ein Verfahren zum Herstellen gedruckter Schaltungen bekannt, bei dem auf einen aufgerauhten, unkaschierten Isolierstoffträger eine Kleberschicht aufgebracht wird, die mit Zinn und Palladium aktiviert wird und eine Metallauflage durch Auftragen einer höchstens 0,5 µm starken Kupfergrundschicht mittels stromloser chemischer Verkupferung auf der gesamten Oberfläche einschließlich eventueller Bohrungen der Trägerplatte gebildet wird. Die Kupfergrundschicht wird anschließend durch eine galvanische Behandlung auf etwa 1 bis 2 µm verstärkt, und nach dem Aufbringen einer Abdeckung erfolgt eine weitere galvanische Verstärkung der nicht abgedeckten Teile, wobei die Entfernung der Abdeckung und das Wegätzen der nicht gewünschten Teile des Kupferbelags nach bekannten Verfahren erfolgen. Ein Verfahren zum galvanischen Verstärken einer Kupferschicht im Bereich von Bohrungen einschließlich der Lötaugen ist auch in der deutschen Offenlegungsschrift 1 924 775 beschrieben. Ein Verfahren zur Herstellung von durchkontaktierten gedruckten Schaltungen, bei welchem von einem Dünnschichtkupferlaminat mit beidseitig aufkaschierten Dünnschicht-Kupferfolien und mechanisch abziehbaren Schutzfolien ausgegangen wird und bei dem nach dem Bohren der Löcher die Lochwandungen stromlos und galvanisch verkupfert werden, sodann die Schutzfolien abgezogen, das gewünschte Leiterbild und die Lochwandungen durch selektive galvanische Kupferabscheidung unter Verwendung von Galvanikabdeckungen verstärkt und schließlich die nicht verstärkten Bereiche der Dünnschicht-Kupferfolien abgeätzt werden, ist in der deutschen Offenlegungsschrift 2 515 706 beschrieben.

In der Patentliteratur und insbesondere in den zuvor genannten Patentschriften wird jedoch kein Verfahren zum Herstellen von Leiterplatten beschrieben, bei dem, wie bei dem erfindungsgemäßen, die Oberflächen von Leiterplatten und die Wandungen von Bohrlöchern anstelle einer Aktivierung mit einer Palladium-Zinn-(II)-chloridlösung in einem Trockenprozeß mit Kupfer besputtert wird und bei dem anschließend im Bereich der Leiterzüge und an den Bohrlochwandungen ein Kupferaufbau nach dem galvanischen Verfahren unter Verwendung eines sauren Elektrolytbades erfolgt. Mit dem erfindungsgemäßen Verfahren können Leiterplatten mit einer Leiterzugbreite und Abständen von etwa 100 μm und darunter und einem Höhen- zu Breitenverhältnis der Leiterzüge von etwa 1 : 3 hergestellt werden. Die nach dem erfindungsgemäßen Verfahren hergestellten Leiterplatten weisen keinerlei Leckstromfehler auf. Das erfindungsgemäße Verfahren, bei dem ein Trockenprozeß zur Aktivierung mit einem Kupferaufbau im Bereich der Leiterzüge und der Bohrlöcher nach dem galvanischen Verfahren kombiniert wird, ist besonders für Spezialanwendungen geeignet. Da der galvanische Kupferaufbau nur in sauren Bädern stattfindet, kann ein in wässrig-alkalischen Medien löslicher und strippbarer Photoresist verwendet werden. Dadurch wird das Verfahren besonders umweltfreundlich. Zur Aufarbeitung der bei der Entwicklung anfallenden Bäder wird der Resist ausgeflockt und die Restalkalität das Bades neutralisiert. Bei der Entwicklung entstehen keinerlei Abluftprobleme.

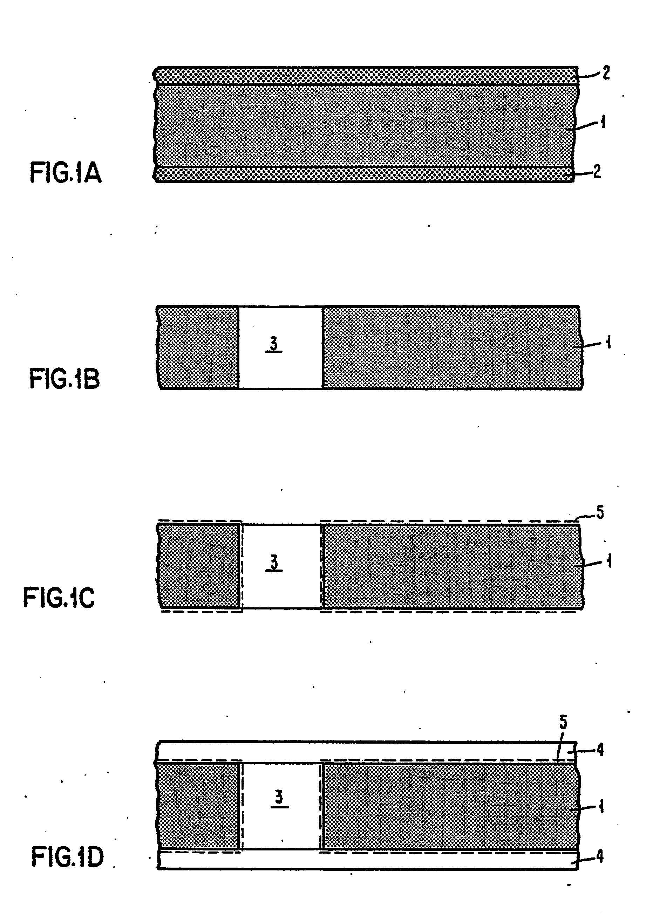

Die Erfindung wird nunmehr anhand eines Ausführungsbeispiels in Verbindung mit den Figuren 1A bis 1G und anhand eines Flußdiagramms näher erläutert. Die Figuren 1A bis 1G zeigen schematische Querschnittsansichten einer gemäß dem bevorzugten Ausführungsbeispiel der vorliegenden Erfindung hergestellten Struktur. In den Figuren 2A und 2B, rechte Seite, sind die dazu gehörigen Verfahrensschritte angegeben. Auf der linken Seite sind die Verfahrensschritte des Additivverfahrens angegeben.

Ausführungsbeispiel:

Gemäß Figur 1A und dem Flußdiagramm, rechte Seite (Figuren 2A und 2B), werden vier grün eingefärbte Prepregs auf Epoxidharzbasis 1 mit sogenannten Opferfolien 2 aus Kupfer bei etwa 190 °C zusammenlaminiert. Durch die Grünfärbung des Prepregs wird die optische Inspektion erleichtert. Bei den angewendeten 1/2 oder 1 oz Opferfolien handelt es sich um Kupferfolien mit Dicken von 0,0175 bzw. 0,035 mm. Durch das Auflaminieren der Opferfolien 2 wird bewirkt, daß das Signalebenenlaminat stabilisiert wird, und daß sich die dendritische Struktur der Unterseite der Kupferfolien während des Laminierens in der Oberfläche des Epoxidharzlaminats abbildet und dort eine gewünschte Rauhigkeit erzeugt.

In das kupferbeschichtete Laminat 1, 2 werden Justagelöcher (nicht dargestellt) eingestanzt. Anschließend werden mit Hilfe numerisch gesteuerter Automaten Löcher 3 in das kupferbeschichtete Laminat gebohrt zur Herstellung der Verbindung zwischen der X- und Y-Verdrahtung. Bei dem erfindungsgemäßen Verfahren ist von Vorteil, daß vor dem Bohren nicht wie bei dem bisher bekannten Verfahren (Figur 2A, linke Seite) eine Photoresistschicht aufgetragen werden muß, weil das Teil 1 durch die Opferfolien 2 bereits über eine genügende Eigenfestigkeit verfügt. Es entfällt auch eine separate Reinigung der Bohrlöcher, weil die Kupferschichten 2 nach dem Bohren der Löcher in einer

Hochdrucksprühanlage mit CuCl$_2$ abgeätzt werden. Nach diesem Schritt liegt ein gebohrtes, gereinigtes und auf der Oberfläche stark aufgerauhtes Laminat (Figur 1B) vor.

Das Laminat wird nunmehr in einer Durchlaufsputteranlage, die mit vier magnetronverstärkten Kupferkathoden ausgestattet ist, beidseitig ganzflächig mit Kupfer 5 (Figur 1C) besputtert. Beide Seiten werden gleichzeitig besputtert, bis eine Schichtdicke von etwa 200 nm erreicht ist. Die Schichtdicke des aufgesputterten Kupfers liegt im allgemeinen zwischen 80 und 500 nm. Die Parameter für diesen Verfahrensschritt im einzelnen sind folgende:

| | |
|---|---|
| Startdruck: | $\leq 5 \times 10^{-5}$ mbar; |
| Sauerstoffglimmentladung zur Reinigung: | 2 Minuten; |
| O$_2$-Partialdruck: | $2 \times 10^{-1}$ mbar; |
| Argonpartialdruck: | $5 \times 10^{-3}$ mbar; |
| Argondurchfluß: | 80–150 cm$^3$/min.; |
| Durchlaufgeschwindigkeit: | 1–3 cm/sek.; |
| Substrattemperatur: | $\leq 80°C$; |
| Sputterrate: | ~ 10 nm/sek. |
| Kupferschichtdicke: | 200 nm. |

Das Kupfer 5, welches sich während des Sputterns auf der Substratoberfläche und auf den Bohrlochwandungen abgeschieden hat, ersetzt die bisher angewendeten aufwendigen und teuren Palladium-Zinn-(II)-chlorid-Aktivierungsprozesse (Figur 2A, linke Seite).

Anschließend wird eine Negativphotoresistfolie 4, beispielsweise Riston 3315 von der Firma du Pont, welcher ein Resist auf der Basis von Polyäthylenterephthalat, Benzophenon und Acrylsäure/Styrol-Polymer ist, beidseitig auf das aufgerauhte, mit Kupfer besputterte Substrat 1 auflaminiert (Figur 1D). Während des Laminiervorgangs, der bei etwa 110 bis 120 °C und bei einem Vorschub von etwa 1 cm/sek. durchgeführt wird, wird die Photoresistfolie so weich, daß sie sich fugenlos dem Untergrund in seiner Rauhigkeit anpaßt. Im allgemeinen ist nicht erforderlich, die Substratoberfläche mit einem Haftvermittler, wie Benztriazol, vorzubereiten. Der Einsatz von Benztriazol kann jedoch, insbesondere als Korrosionsschutz, von Vorteil sein. Das Laminat wird anschließend in bekannter Weise durch eine Maske auf Vorder- und Rückseite belichtet. Anschließend wird der Photoresist in einer Durchlaufanlage mit einer etwa 1,5 bis 2 Gew.%-igen Natriumcarbonatlösung bei etwa 30 bis 40 °C entwickelt (Figur 1E). Die Aufarbeitung des Entwicklers erfolgt, wie bereits zuvor angegeben, durch Ausflocken des Resists und Neutralisation der Restalkalität.

Nach einer Inspektion werden die Leiterplatten in ein galvanisches Bad eingebracht. Dazu werden die Leiterplatten in einen Rahmen geschoben mit allseitiger Kontaktierung an der aufgesputterten Kupferschicht, oder es wird, für die Kontaktierung der Lei-

4

terplatte, beim Abätzen der Opferfolie ein etwa 1 cm breiter Rand stehengelassen, an dem Kontaktschrauben (Spann- oder Klemmschrauben) angebracht werden können.

Da galvanische Bäder nur in einem bestimmten Stromdichtebereich optimal arbeiten, ist es nur wichtig, die zu galvanisierende Oberfläche einer Leiterplatte möglichst genau zu kennen. Diese Oberfläche besteht aus dem Leiterzugbild selbst und aus der durch die Bohrungen gebildeten Oberfläche. Eine sehr einfache und schnelle Methode zur Bestimmung der aktiven Oberfläche einer Leiterplatte ist auf optischem Wege möglich. Das hierfür verwendete Gerät bestimmt den Anteil des Lichts, der bei der Durchleuchtung vor einer gleichmäßig ausgeleuchteten Scheibe entweder vom positiven oder negativen Bildanteil des Filmbildes absorbiert wird.

Für den galvanischen Kupferaufbau werden schwefelsaure Bäder mit geringem Metallgehalt und hohem Schwefelsäureanteil verwendet. Die Konzentrationen der einzelnen Badbestandteile sollten innerhalb folgender Grenzen liegen:

|  |  | für ein einzelnes Bad |
| --- | --- | --- |
| $Cu^{2+}$ | 15–25 g/l | 15 g/l (0,23 mol/l) |
| $H_2SO_4$ | 170–200 g/l | 170 g/l (1,73 mol/l) |
| $Cl^-$ | 40–60 mg/l | 40 mg/l ($1,128 \cdot 10^{-3}$ mol/l) |

Der Elektrolyt kann auch einen Glanzbildner, beispielsweise GS 818 der Firma Schering enthalten, der aus einem Amid der allgemeinen Formel R-CO-$NH_2$, in der R einen aliphatischen oder aromatischen, monomeren oder polymeren Kohlenwasserstoffrest bedeutet und aus einem Polyäthylenglykol und einer organischen Schwefelverbindung aufgebaut ist. Der Gehalt des Elektrolyts an Glanzbildner beträgt in vorteilhafter Weise etwa 5 bis 15 g/l. Die Arbeitstemperatur des Bades liegt bei etwa 20 bis 25 °C. Um eine gute Verteilung der Kupferschicht, insbesondere in den Bohrungen, zu erhalten, ist eine Bewegung der Leiterplatten von und zu den Anoden erforderlich. Die Bewegung der Leiterplatten erfolgt mit etwa 0,5 bis 0,9 m/min., wobei die optimale Einstellung durch Versuche zu ermitteln ist. Eine zusätzliche Elektrolytbewegung kann durch Einblasen ölfreier Luft herbeigeführt werden.

Der optimale kathodische Stromdichtebereich für die Abscheidung gleichmäßiger Kupferschichten liegt zwischen etwa 2,5 und 3 A/dm² und ist von der Badetemperatur, der Bewegung der Leiterplatten und von deren Geometrie abhängig. Bei Stromdichten von etwa 2,5 A/dm² wird eine Abscheidungsrate von etwa 25 bis 30 µm/h erhalten.

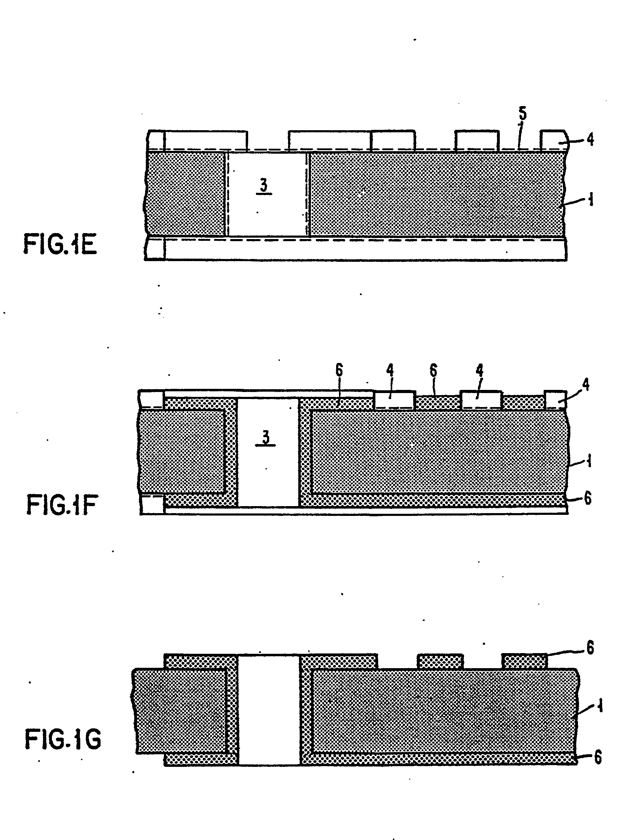

Nach der galvanischen Verkupferung 6 wird die Photoresistmaske 4 (Figur 1F) mit einer alkalisch wässrigen Lösung gestrippt. Hierzu wird in vorteilhafter Weise eine etwa 1 bis 3 Gew.%-ige Natriumhydroxidlösung verwendet. Nach dem Strippen des Photoresists wird in den freigelegten Bereichen das aufgesputterte Kupfer 5 durch Differenzätzen entfernt (Figur 1G). Die hierzu verwendete Ätzlösung enthält etwa 100 bis 130 g/l Natriumperoxidisulfat und 60 bis 90 ml/l konzentrierte Schwefelsäure.

Das Differenzätzen wird in einer Anlage mit einem Sprühdruck von etwa 3 bar, einer Durchlaufgeschwindigkeit der Platten von etwa 1,5 m/min. und bei Raumtemperatur (etwa 25 °C) durchgeführt. Die Leiterplatten werden anschließend visuell und elektrisch geprüft.

Bei dem erfindungsgemäßen Verfahren, bei dem die zu galvanisierende Oberfläche der Leiterplatten durch aufgesputtertes Kupfer aktiviert wird und der Kupferaufbau galvanisch erfolgt, kann eine Schichtdickenverteilung des Kupfers erhalten werden, die weniger als 3 % vom Mittelwert abweicht, d. h., bei einer Kupferschichtdicke von 300 nm wird eine Abweichung von unter 9 nm erhalten.

**Patentansprüche**

1. Verfahren zum Herstellen von gedruckten Schaltungen mit den folgenden Verfahrensschritten:
   a) Auflaminieren einer Opferfolie (2) auf ein Kunstharzprepreg (1);
   b) Bohren von Verbindungslöchern (3);
   c) Abätzen der Opferfolie (2);
   d) Aufsputtern von Kupfer (5) auf die Prepregoberfläche und die Bohrlochwandungen;
   e) Auflaminieren einer Negativphotoresistfolie (4) auf die Prepregoberfläche;
   f) Belichten der Photoresistfolie (4) entsprechend den gewünschten Leiterzugmuster und Entwickeln;
   g) galvanisches Abscheiden von Kupfer (6) auf dem aufgesputterten Kupfer in den durch den Verfahrensschritt f) hergestellten Photoresistkanälen und an den Bohrlochwandungen;
   h) Strippen des Photoresists (4);
   i) Differenzätzen zur Entfernung des aufgesputterten Kupfers von den nicht mit Leiterzügen bedeckten Bereichen des Prepregs (1).

2. Verfahren nach Anspruch 1, dadurch gekennzeichnet, daß die Schritte a) und c) bis h) auf beiden Seiten des Basismaterials (1) gleichzeitig durchgeführt werden.

3. Verfahren nach Anspruch 1 oder 2, dadurch gekennzeichnet, daß gemäß 1a) Opferfolien (2) aus Kupfer mit Dicken von etwa 0,0175 bis 0,03 mm bei etwa 190 °C auf das Prepreg (1) auflaminiert werden.

4. Verfahren nach Anspruch 1, dadurch gekennzeichnet, daß gemäß 1c) die Opferfolie (2) aus Kupfer in einer Hochdrucksprühanlage mit salzsaurer Kupfer-(II)-chloridlösung abgeätzt wird.

5. Verfahren nach Anspruch 1, dadurch gekennzeichnet, daß gemäß 1d) mittels magnetronverstärkter Hochleistungskathodenzerstäubung Kupfer (5) auf die Prepregoberfläche und die Bohrlochwandungen in einer Schichtdicke von etwa 80 bis 500 nm aufgebracht wird.

6. Verfahren nach Anspruch 5, dadurch gekennzeichnet, daß mittels magnetronverstärkter Hochleistungskathodenzerstäubung Kupfer (5) auf die Prepregoberfläche und die Bohrlochwandungen in einer Schichtdicke von 200 nm aufgebracht wird.

7. Verfahren nach Anspruch 1, dadurch gekennzeichnet, daß gemäß 1e) eine Negativphotoresistfolie (4) durch Laminieren bei Temperaturen von etwa 110 bis 120 °C nahtlos mit der mit Kupfer (5) besputterten Oberfläche des Epoxidharzprepregs (1) verbunden wird.

8. Verfahren nach Anspruch 7, dadurch gekennzeichnet, daß eine Negativphotoresistfolie (4) auf der Basis von Polyäthylenterephthalat, Benzophenon und Acrylsäure/Styrol-Polymer auf die mit Kupfer (5) besputterte Oberlfäche des Epoxidharzprepregs (1) auflaminiert, dem gewünschten Leiterzugmuster entsprechend belichtet und in wässrig alkalischer Lösung entwickelt wird.

9. Verfahren nach Anspruch 1, dadurch gekennzeichnet, daß die Leiterplatten zum galvanischen Abscheiden von Kupfer (6) auf dem aufgesputterten Kupfer (5) in den Photoresistkanälen und an den Bohrlochwandungen in ein Bad mit einem Gehalt an 15 bis 25 g/l $Cu^{2+}$, 170 bis 200 g/l $H_2SO_4$, 40 bis 60 mg/l $Cl^-$ und gegebenenfalls 5 bis 15 g/l Glanzbildner eingebracht werden.

10. Verfahren nach Anspruch 9, dadurch gekennzeichnet, daß zur galvanischen Abscheidung von Kupfer eine Stromdichte von etwa 2,5 A/dm² angewendet wird, wodurch eine Abscheidungsrate von etwa 25 bis 30 µm/h erhalten wird.

11. Verfahren nach Anspruch 1, dadurch gekennzeichnet, daß gemäß 1h) der Photoresist (4) in einer wässrig alkalischen Lösung gestrippt wird.

12. Verfahren nach Anspruch 1, dadurch gekennzeichnet, daß das gemäß 1i) aufgesputterte Kupfer (5) von den nicht mit Leiterzügen bedeckten Oberflächenbereichen des Epoxidharzprepregs (1) durch Differenzätzen in einer Lösung mit einem Gehalt an 100 bis 130 g/l Natriumperoxidisulfat und 60 bis 90 ml/l konzentrierter Schwefelsäure entfernt wird.

## Claims

1. Process for producing printed circuits, comprising the steps of
   a) laminating a sacrificial foil (2) to a synthetic resin prepreg (1);
   b) drilling throughholes (3);
   c) etching the sacrificial foil (2);
   d) sputtering copper (5) onto the prepreg surface and the hole walls;
   e) laminating a negative photoresist foil (4) to the prepreg surface;
   f) exposing the photoresist foil (4) according to the desired conductor pattern, and developing;
   g) depositing copper (6) by electroplating on the sputtered copper in the photoresist channels presented in step f) and on the hole walls;
   h) stripping the photoresist (4);
   i) removing the sputtered copper by differential etching from the regions of prepreg (1) not containing conductors.

2. Process according to claim 1, characterized in that steps a) and c) to h) are simultaneously implemented on both sides of the base material (1).

3. Process according to claim 1 or 2, characterized in that according to 1a), sacrificial foils (2) of copper with thicknesses of about 0.0175 to 0.03 are laminated to the prepreg (1) at about 190°C.

4. Process according to claim 1, characterized in that according to 1c), the sacrificial foil (2) of copper is etched in a high-pressure spray system with a hydrochloric acid copper-(II)-chloride solution.

5. Process according to claim 1, characterized in that according to 1d), by magnetronenhanced high-power cathode sputtering, copper (5) with a layer thickness of about 80 to 500 nm is applied to the prepreg surface and the hole walls.

6. Process according to claim 5, characterized in that by means of magnetron-enhanced high-power cathode sputtering, copper (5) with a layer thickness of 200 nm is applied to the prepreg surface and the hole walls.

7. Process according to claim 1, characterized in that according to 1e), by lamination at temperatures of about 110 to 120°C, a negative photoresist foil (4) is applied to the surface of the epoxy resin prepreg (1) sputtered with copper (5), forming an integral structure therewith.

8. Process according to claim 7, characterized in that a negative photoresist foil (4) on the basis of polyethylene terephthalate, benzophenone and acryl acid/styrol polymer is laminated to the surface of the epoxy resin prepreg (1) sputtered with copper (5), exposed according to the desired conductor configuration and developed in an aqueous alkaline solution.

9. Process according to claim 1, characterized in that for copper-plating the sputtered copper (5) in the photoresist channels and on the hole walls, the circuit boards are placed in a bath containing 15 to 25 g/l $Cu^{2+}$, 170 to 200 g/l $H_2SO_4$, 40 to 60 mg/l $Cl^-$, and, if necessary, 5 to 15 g/l brightener.

10. Process according to claim 9, characterized in that for copper plating, a current density of about 2.5 A/dm² is used, yielding a deposition rate of about 25 to 30 µm/h.

11. Process according to claim 1, characterized in that according to 1h), the photoresist (4) is stripped in an aqueous alkaline solution.

12. Process according to claim 1, characterized in that the copper (5) sputtered according to 1i) is removed from the surface regions of the epoxy resin prepreg (1) not containing conductors by differential etching in a solution containing 100 to 130 g/l sodium peroxodisulphate and 60 to 90 ml/l concentrated sulphuric acid.

## Revendications

1. Procédé de fabrication de circuits imprimés, comportant les stades opératoires suivants:
   a) on applique par stratification une feuille perdue (2) sur une feuille préimprégnée de matière plastique (1);
   b) on perce des trous de liaison (3);
   c) on corrode la feuille perdue (2);
   d) on applique par pulvérisation cathodique du cuivre (5) sur la surface de la feuille préimprégnée et sur les parois des trous;
   e) on applique par stratification une feuille photorésistive ou épargne gravure négative (4) à la surface de la feuille préimprégnée;

f) on expose à la lumière la feuille photorésistive (4) selon la configuration de tracés conducteurs souhaitée et on la développe;

g) on dépose galvaniquement du cuivre (6) sur le cuivre appliqué par pulvérisation cathodique dans les canaux de matière photorésistive produits par le stade opératoire (f) et sur les parois des trous;

h) on élimine la matière photorésistive (4);

i) on effectue une corrosion différentielle pour retirer le cuivre déposé par pulvérisation cathodique des zones de la feuille préimprégnée (1) non recouvertes de tracés conducteurs.

2. Procédé selon la revendication 1, caractérisé en ce qu'on effectue les stades (a) et (c) à (h) en même temps des deux côtés de la matière de base (1).

3. Procédé selon la revendication 1 ou 2, caractérisé en ce qu'on applique par stratification selon (1a) des feuilles perdues (2) de cuivre d'épaisseur d'environ 0,0175 à 0,03 mm à environ 190°C sur la feuille préimprégnée (1).

4. Procédé selon la revendication 1, caractérisé en ce que selon (1c), on corrode la feuille perdue (2) de cuivre dans une installation de pulvérisation à haute pression avec une solution chlorhydrique de chlorure cuivrique.

5. Procédé selon la revendication 1, caractérisé en ce que, selon (1d), on applique par pulvérisation cathodique à haute puissance avec amplification par magnétron du cuivre (5) sur la surface de la feuille préimprégnée et sur les parois des trous avec une épaisseur de couche d'environ 80 à 500 nm.

6. Procédé selon la revendication 5, caractérisé en ce qu'on applique par pulvérisation cathodique à haute puissance avec amplification par magnétron du cuivre (5) sur la surface de la feuille préimprégnée et sur les parois des trous avec une épaisseur de couche de 200 nm.

7. Procédé selon la revendication 1, caractérisé en ce que, selon (1e), on applique avec une liaison sans soudure une feuille photorésistive négative (4) par stratification à des températures d'environ 110 à 120°C sur la surface de la feuille préimprégnée de résine époxyde (1) sur laquelle du cuivre (5) a été appliqué par pulvérisation cathodique.

8. Procédé selon la revendication 7, caractérisé en ce qu'on applique par stratification une feuille photorésistive négative (4) à base de téréphtalate de polyéthylène, de benzophénone et de polymère acide acrylique/styrène sur la surface de la feuille préimprégnée de résine époxyde (1) sur laquelle du cuivre (5) a été appliqué par pulvérisation cathodique, on l'expose à la lumière selon la configuration de tracés conducteurs souhaitée et on la développe dans une solution alcaline aqueuse.

9. Procédé selon la revendication 1, caractérisé en ce qu'on introduit les plaquettes de circuits imprimés, pour le dépôt galvanique de cuivre (6) sur le cuivre (5) appliqué par pulvérisation cathodique dans les canaux de matière photorésistive et sur les parois des trous, dans un bain contenant de 15 à 25 g/l de $Cu^{2+}$, 170 à 200 g/l de $H_2SO_4$, 40 à 60 mg/l de $Cl^-$ et éventuellement 5 à 15 g/l de lustrant.

10. Procédé selon la revendication 9, caractérisé en ce que, pour le dépôt galvanique de cuivre, on applique une densité de courant d'environ 2,5 $A/dm^2$, ce qui permet d'obtenir une vitesse de dépôt d'environ 25 à 20 um/h.

11. Procédé selon la revendication 1, caractérisé en ce que, selon (1h), on élimine la matière photorésistive (4) dans une solution alcaline aqueuse.

12. Procédé selon la revendication 1, caractérisé en ce que l'on retire le cuivre (5) appliqué par pulvérisation cathodique selon (1i) des zones de la surface de la feuille préimprégnée de résine époxyde (1) non recouvertes de tracés conducteurs par corrosion différentielle dans une solution contenant 100 à 130 g/l de peroxydisulfate de sodium et 60 à 90 ml/l d'acide sulfurique concentré.

FIG.1A

FIG.1B

FIG.1C

FIG.1D

FIG.1E

FIG.1F

FIG.1G

EP 0 227 857 B1

| PROZESS STAND DER TECHNIK | PROZESS GEMÄSS DER ERFINDUNG |

```
PROZESS                          PROZESS
STAND DER TECHNIK                GEMÄSS DER ERFINDUNG
```

┌─────────────────────────────┐      ┌─────────────────────────────┐
│ AUF PREPREG                 │      │ AUF PREPREG                 │
│ ZWEISCHICHTIGE              │      │ OPFERFOLIE AUF-             │
│ KUPFERFOLIE (5 u. 70 μm)    │      │ LAMINIEREN                  │
│ AUFLAMINIEREN               │      │                             │
└─────────────────────────────┘      └─────────────────────────────┘

┌─────────────────────────────┐
│ TRÄGERFOLIE                 │
│ ENTFERNEN                   │
└─────────────────────────────┘

┌─────────────────────────────┐
│ SPITZEN ABTRAGEN            │
│ DURCH SCHLEIFEN             │
│ DER OBERFLÄCHE              │
└─────────────────────────────┘

┌─────────────────────────────┐
│ REINIGEN                    │
│ UND                         │
│ TROCKNEN                    │
└─────────────────────────────┘

┌─────────────────────────────┐
│ NEGATIVPHOTORESIST          │
│ AUFTRAGEN UND               │
│ GANZFLÄCHIG                 │
│ BELICHTEN                   │
└─────────────────────────────┘

┌─────────────────────────────┐      ┌─────────────────────────────┐
│ JUSTIERLÖCHER               │      │ JUSTIERLÖCHER               │
│ STANZEN                     │      │ STANZEN                     │
└─────────────────────────────┘      └─────────────────────────────┘

┌─────────────────────────────┐      ┌─────────────────────────────┐
│ SIGNALEBENENLÖCHER          │      │ SIGNALEBENEN-               │
│ BOHREN UND                  │      │ LÖCHER BOHREN               │
│ ENTGRATEN                   │      │                             │
└─────────────────────────────┘      └─────────────────────────────┘

                                     ┌─────────────────────────────┐
                                     │ OPFERFOLIE ABÄTZEN          │
                                     └─────────────────────────────┘

┌─────────────────────────────┐
│ LÖCHER REINIGEN             │
└─────────────────────────────┘

┌─────────────────────────────┐
│ MIT PALLADIUMCHLORID-       │
│ ZINN-II-CHLORID             │
│ AKTIVIEREN                  │
└─────────────────────────────┘

                                     ┌─────────────────────────────┐
                                     │ KUPFER                      │
                                     │ AUFSPUTTERN                 │
                                     └─────────────────────────────┘

┌─────────────────────────────┐
│ RESIST STRIPPEN             │
└─────────────────────────────┘

FIG. 2A

MIT BENZTRIAZOL
VORBEHANDELN

NEGATIVPHOTORESIST—
FOLIE AUF—
LAMINIEREN

NEGATIVPHOTORESIST—
FOLIE AUF—
LAMINIEREN

DEM LEITERZUGMUSTER
ENTSPRECHEND
BELICHTEN

DEM LEITERZUGMUSTER
ENTSPRECHEND
BELICHTEN

IN CHLORIERTEM
KOHLENWASSERSTOFF
ENTWICKELN

IN WÄSSRIG ALKALISCHER
LÖSUNG ENTWICKELN

PRÜFEN

PRÜFEN

KUFPERAUFBAU
NACH DEM
ADDITIVVERFAHREN

KUPFERAUFBAU
NACH DEM
GALVANISCHEN VERFAHREN

LEITERZÜGE
SCHUTZVERZINNEN

RESIST STRIPPEN

RESIST STRIPPEN

KUPFERFOLIE
ABÄTZEN

DIFFERENZÄTZEN
ZUR ENTFERNUNG DES
AUFGESPUTTERTEN KUPFERS

SCHUTZZINN
ENTFERNEN

INSPEKTION
UND
REPARATUR

INSPEKTION
UND
REPARATUR

ELEKTRISCH PRÜFEN

ELEKTRISCH PRÜFEN

FIG. 2B